# EUROPEAN PATENT APPLICATION

(11) **EP 4 539 095 A1**
(43) Date of publication of application: **16.04.2025**
(21) Application number: 23203523.8
(22) Date of filing: 13.10.2023
(51) Int. Cl.: H01L 21/02

(54) **FIN-TYPE AND COMPLEMENTARY-TYPE FIELD-EFFECT TRANSISTORS**

(71) Applicant: Imec VZW, 3001 Leuven (BE)
(72) Inventor: SEBAAI, Farid, 1140 Evere (BE)
(74) Representative: Winger

(57) **Abstract**

A method for forming one or more fin-type or complementary-type field-effect transistors, comprising:
i) providing a first intermediate structure (1, 12) comprising:
- a layer to be patterned (3, 8), and
- a first hard mask (4, 9) having openings (40, 91),

ii) dry etching the layer (3,8) through the openings (40, 91) in the hard mask (4, 9), thereby forming a second intermediate structure (10, 13), wherein the second intermediate structure (10, 13) comprises one or more exposed oxide surfaces,
iii) reacting said exposed oxide surfaces with a silane compound (5) of chemical formula R-Si(R¹)ₙ(OR²)₃₋ₙ, wherein R is an organyl group, R¹ is selected from hydrogen, hydroxyl, halogen, and an organyl group, R² is selected from hydrogen and an organyl group, and n is an integer selected in the range of from 0 to 2, and then
iv) cleaning the second intermediate structure (10, 13) having reacted oxide surfaces by contacting it with a solution (6) comprising hydrogen fluoride.

## Description

### Technical field of the invention

The present invention relates to the field of fin-type and complementary-type field-effect transistors.

### Background of the invention

In the state of the art, fin-type and complementary-type field-effect transistors are increasingly utilized in integrated circuit chips to achieve a high transistor density or, correspondingly, smaller semiconductor nodes. Fin-type field-effect transistors include any type of field-effect transistors comprising a fin-shaped channel or gate. An example is the fin field-effect transistor (FinFETs). Complementary-type field-effect transistors (CFET) contain n-type gate-all-around field effect transistors stacked on p-type gate-all-around field effect transistors.

For these devices, the scale becomes so small that even minor impurities or minor damages may deteriorate their functionality.

Typically, dry etching is employed to shape the channel or gate for these devices. Dry etching, however, tends to inflict damage on oxide surfaces, due to the bombardment of plasma ions with said oxide surfaces. The subsequent cleaning step with a hydrogen fluoride solution, usually applied to remove (oxide-like) residues resulting from the dry etching step, has been found to further damage these oxide surfaces, which may cause several problems. For example, when the oxide surfaces of a hard mask become damaged, protection of the material underneath the hard mask during subsequent etch steps may be reduced. As another example, when the oxide surfaces of shallow trench isolations become damaged, electrical insulation between adjacent transistors may be weakened. As still another example, when the oxide surfaces of gate oxides become damaged, electrical insulation between the gate metal and the channel of a transistor may be weakened. Although the concentration of hydrogen fluoride in the solution that is used may be very low to prevent said further damage, it conversely results in less efficient removal of the residues.

There is thus still a need in the art for devices and methods that address at least some of the above problems.

### Summary of the invention

It is an object of the present invention to provide a method for forming one or more fin-type or complementary-type field-effect transistors having a good functionality.

It is a further object of the present invention to provide an intermediate in the formation of a plurality of fin-type or complementary-type field-effect transistors having a good functionality.

The above objective is accomplished by a method and intermediate according to the present invention.

One advantage of embodiments of the present invention is that oxide surfaces can be protected during the cleaning step by a silane compound, which is resistant to hydrogen fluoride. Another advantage of embodiments of the present invention is that damage to oxide surfaces may be prevented when cleaning with a solution containing hydrogen fluoride. Furthermore, an additional advantage of embodiments of the present invention is that this prevention of damage is achievable even when using solutions with high concentrations of hydrogen fluoride, thereby facilitating efficient removal of oxide-like residues typically generated during the dry etching process. Thus, an advantage of embodiments of the present invention is that the functionality of the formed fin-type or complementary-type field-effect transistors, which are highly sensitive to such damage and residue contamination, may be well preserved.

In a first aspect, the present invention relates to a method for forming one or more fin-type or complementary-type field-effect transistors, comprising:
i) providing a first intermediate structure comprising:
   - a layer to be patterned, and
   - a first hard mask having openings,
ii) dry etching the layer through the openings in the hard mask, thereby forming a second intermediate structure, wherein the second intermediate structure comprises one or more exposed oxide surfaces,
iii) reacting said exposed oxide surfaces with a silane compound of chemical formula R-Si(R¹)ₙ(OR²)₃₋ₙ, wherein R is an organyl group, R¹ is selected from hydrogen, hydroxyl, halogen, and an organyl group, R² is selected from hydrogen and an organyl group, and n is an integer selected in the range of from 0 to 2, and then
iv) cleaning the second intermediate structure having reacted oxide surfaces by contacting it with a solution comprising hydrogen fluoride.

In a second aspect, the present invention relates to an intermediate in the formation of a plurality of fin-type or complementary-type field-effect transistors, comprising:
- a substrate
- a plurality of fins comprising a channel material, protruding from the substrate, and
- recesses in the substrate between the fins,
- shallow trench isolations located in the recesses and formed of an oxide material, and
- a plurality of gates or dummy gates, and
- a first hard mask overlying and aligned with the plurality of gates or dummy gates,
the intermediate comprising oxide surfaces covered by a silane compound bonded to said oxide surfaces, said silane compound having a chemical formula R-Si(R¹)ₙ(OR²)₂₋ₙ, wherein R is an organyl group, R¹ is selected from hydrogen, hydroxyl, halogen, and an organyl group, R² is selected from hydrogen and an organyl group, and n is an integer selected in the range of from 0 to 2.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1A and FIG. 1B are schematic representations of a top view and a vertical cross-section, respectively, of a first intermediate structure according to a first example in accordance with embodiments of the present invention.
FIG. 2 is a schematic representation of a vertical cross-section of a second intermediate structure according to the first example in accordance with embodiments of the present invention.
FIG. 3 is a schematic representation of a vertical cross-section of the second intermediate structure wherein oxide surfaces are reacted with a silane compound, according to the first example in accordance with embodiments of the present invention.
FIG. 4 is a schematic representation of a vertical cross-section of the second intermediate structure wherein oxide surfaces are reacted with a silane compound, to which a solution comprising hydrogen fluoride is applied, according to the first example in accordance with embodiments of the present invention.
FIG. 5 is a schematic representation of a vertical cross-section of a preliminary intermediate structure according to a second example in accordance with embodiments of the present invention.
FIG. 6A and FIG. 6B are schematic representations of a top view and a vertical cross-section, respectively, of the preliminary intermediate structure, after formation of the shallow trench isolations, according to the second example in accordance with embodiments of the present invention.
FIG. 7 is a schematic representation of a vertical cross-section of the preliminary intermediate structure, after formation of the shallow trench isolations and deposition of an oxide layer, according to the second example in accordance with embodiments of the present invention.
FIG. 8A, FIG. 8B and FIG. 8C are schematic representations of a top view and two different vertical cross-sections, respectively, of a first intermediate structure, according to the second example in accordance with embodiments of the present invention.
FIG. 9A, FIG. 9B and FIG. 9C are schematic representations of a top view and two different vertical cross-sections, respectively, of a second intermediate structure, according to the second example in accordance with embodiments of the present invention.
FIG. 10 is a vertical cross-section of the second intermediate structure wherein oxide surfaces are reacted with a silane compound, according to the second example in accordance with embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein. Unless provided otherwise, when the term "on" is used, it implies physical contact.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

In a first aspect, the present invention relates to a method for forming one or more fin-type or complementary-type field-effect transistors, comprising:
i) providing a first intermediate structure comprising:
   - a layer to be patterned, and
   - a first hard mask having openings,
ii) dry etching the layer through the openings in the hard mask, thereby forming a second intermediate structure, wherein the second intermediate structure comprises one or more exposed oxide surfaces,
iii) reacting said exposed oxide surfaces with a silane compound of chemical formula R-Si(R¹)ₙ(OR²)₃₋ₙ, wherein R is an organyl group, R¹ is selected from hydrogen, hydroxyl, halogen, and an organyl group, R² is selected from hydrogen and an organyl group, and n is an integer selected in the range of from 0 to 2, and then
iv) cleaning the second intermediate structure having reacted oxide surfaces by contacting it with a solution comprising hydrogen fluoride.

The oxide surfaces are surfaces of an oxide material. The oxide material is typically silicon dioxide, but may alternatively be, for example, a gallium oxide or an aluminum oxide.

In embodiments, the layer to be patterned is a layer of gate or dummy gate material and the second intermediate structure comprises one or more gates or dummy gates. The gate material may be polycrystalline silicon, Ta, TaN, Nb or WN/RuO₂. The dummy gate material may be a material, such as polycrystalline silicon, amorphous silicon, or microcrystal silicon, that may, in a later stage, be selectively etched and replaced with a gate material.

In embodiments, the method may be for forming a plurality of fin-type or complementary-type field-effect transistors, wherein the first intermediate structure comprises:
- a substrate,
- a plurality of fins comprising a channel material, protruding from the substrate, and
- recesses in the substrate between the fins,
- shallow trench isolations located in the recesses and formed of an oxide material,
- said layer of gate or dummy gate material covering the substrate, the shallow trench isolations, and embedding the plurality of fins.

In these embodiments, forming the first intermediate structure may comprise:
Ia) providing the substrate, then
Ib) providing on the substrate a layer comprising a channel material,
Ic) providing a preliminary hard mask having openings, over the layer comprising a channel material,
Id) dry etching a) the layer comprising a channel material and b) an upper part of the substrate, through the openings in the preliminary hard mask, thereby forming a preliminary intermediate structure comprising the plurality of fins comprising a channel material, said fins protruding from the substrate, and recesses in the substrate between the fins comprising a channel material,
Ie) forming the shallow trench isolations by filling the recesses with an oxide material,
If) covering the substrate, the shallow trench isolations, and the fins comprising a channel material, with the layer of gate or dummy gate material, and
Ig) providing over the gate or dummy gate material the first hard mask having openings.

In these embodiments, the method may further comprise a step Ie' between step Ie and step If of conformally covering the substrate, the shallow trench isolations, and the fins with an oxide material, and wherein step If covers this oxide material.

In embodiments, the channel material may comprise a stack of layers for forming nanosheets. The stack of layers may comprise alternating layers formed of silicon and silicon-germanium. In embodiments, the plurality of fins comprising a channel material comprises a patterned stack of layers for forming nanosheets.

In embodiments, the method is for forming one or more complementary-type field effect transistors, wherein the layer to be patterned comprises a stack of layers for forming nanosheets. In these embodiments, the stack of layers may comprise alternating layers formed of silicon and silicon-germanium.

In embodiments, the group R of the silane compound may comprise a chain of atoms having a chain length of from 1 to 30 atoms, preferably of from 3 to 25 atoms, more preferably from 6 to 20 atoms. In embodiments, the group R¹ and/or the group R² of the silane compound may comprise a chain of atoms having a chain length of from 1 to 30 atoms. The chains may effectively block hydrogen fluoride from reaching the oxide surface. Preferably, the chain of atoms is a carbon chain, i.e., the atoms are carbon atoms. Carbon chains may be particularly unreactive, hence stable, towards hydrogen fluoride.

In embodiments, the group R of the silane compound is selected from (C1-C30)alkyl, (C6-C20)aryl, (C2-C30)alkenyl, (C6-C20)aryl(C1-C30)alkyl, (C1-C30)alkyl(C6-C20)aryl, and (C1-C30)alkoxy, R¹ is selected from hydrogen, hydroxyl, halogen, (C1-C30)alkyl, (C6-C20)aryl, (C6-C20)aryl(C1-C30)alkyl, (C2-C30)alkenyl, and (C1-C30)alkyl(C6-C20)aryl, and R² is selected from hydrogen, (C1-C30)alkyl, halo(C1-C30)alkyl, (C6-C20)aryl, (C6-C20)aryl(C1-C30)alkyl, and (C1-C30)alkyl(C6-C20)aryl, and the alkyl, alkenyl, aryl, arylalkyl, alkoxy, or alkylaryl of R, and the alkyl, haloalkyl, alkenyl, aryl, arylalkyl, or alkylaryl of R¹ may be further substituted with one or more substituents selected from halogen, hydroxyl, -N(R¹¹)(R¹²), -S(R¹³), -C(=O)R¹⁴, and -O-C(=O)R¹⁵ where each of the R¹¹, the R¹², R¹³, R¹⁴, and R¹⁵ is independently selected from hydrogen and (C1-C30)alkyl, (C6-C20)aryl, and (C2-C30)alkenyl. In preferred embodiments, the group R of the silane compound is selected from (C3-C20)alkyl, (C6-C12)aryl, (C6-C12)aryl(C3-C20)alkyl, (C3-C20)alkyl(C6-C12)aryl, R¹ is selected from hydrogen, hydroxyl, halogen, (C1-C20)alkyl, (C6-C12)aryl, (C6-C12)aryl(C1-C20)alkyl, and (C1-C20)alkyl(C6-C12)aryl, and R² is selected from hydrogen, (C1-C20)alkyl, halo(C1-C20)alkyl, (C6-C12)aryl, (C6-C12)aryl(C1-C20)alkyl, and (C1-C20)alkyl(C6-C12)aryl, and the alkyl, aryl, arylalkyl or alkylaryl of R, and the alkyl, aryl, arylalkyl or alkylaryl of R¹ may be further substituted with one or more substituents selected from halogen, hydroxyl, -N(R¹¹)(R¹²) and -S(R¹³), where each of the R¹¹, the R¹², and the R¹³ is independently selected from hydrogen and (C1-C20)alkyl.

In embodiments, the solution may have a concentration of at most 2 wt-% hydrogen fluoride. Preferably, the solution has a concentration of from 0.01 to 2 wt-%, more preferably from 0.1 to 2.0 wt-%, even more preferably from 0.5 to 2.0 wt-%, hydrogen fluoride. It is an advantage of embodiments of the present invention that a large concentration of hydrogen fluoride can be used for cleaning, so that efficient and effective cleaning may be achieved.

In embodiments, the solution is applied for a period of at most 120 seconds to the surfaces of the second intermediate structure. Preferably, the solution is applied for a period of from 1 to 120 second, more preferably from 10 to 120 second. It is an advantage of embodiments of the present invention that the solution comprising hydrogen fluoride can be applied for a long time, so that efficient and effective cleaning may be achieved.

Any features of any embodiment of the first aspect may be independently as correspondingly described for any embodiment of the second aspect of the present invention.

In a second aspect, the present invention relates to an intermediate in the formation of a plurality of fin-type or complementary-type field-effect transistors, comprising:
- a substrate
- a plurality of fins comprising a channel material, protruding from the substrate, and
- recesses in the substrate between the fins,
- shallow trench isolations located in the recesses and formed of an oxide material, and
- a plurality of gates or dummy gates, and
- a first hard mask overlying and aligned with the plurality of gates or dummy gates,
the intermediate comprising oxide surfaces covered by a silane compound bonded to said oxide surfaces, said silane compound having a chemical formula R-Si(R¹)ₙ(OR²)₂₋ₙ, wherein R is an organyl group, R¹ is selected from hydrogen, hydroxyl, halogen, and an organyl group, R² is selected from hydrogen and an organyl group, and n is an integer selected in the range of from 0 to 2.

In embodiments, the group R of the silane compound comprises a chain of atoms having a chain length of from 1 to 30 atoms, preferably of from 3 to 25 atoms, more preferably from 6 to 20 atoms. In embodiments, the group R¹ and/or the group R² of the silane compound comprises a chain of atoms having a chain length of from 1 to 30 atoms. The chains may effectively block hydrogen fluoride from reaching the oxide surface. Preferably, the chain of atoms is a carbon chain, i.e., the atoms are carbon atoms. Carbon chains may be particularly unreactive, hence stable, towards hydrogen fluoride.

In embodiments, the group R of the silane compound is selected from (C1-C30)alkyl, (C6-C20)aryl, (C2-C30)alkenyl, (C6-C20)aryl(C1-C30)alkyl, (C1-C30)alkyl(C6-C20)aryl, and (C1-C30)alkoxy, R¹ is selected from hydrogen, hydroxyl, halogen, (C1-C30)alkyl, (C6-C20)aryl, (C6-C20)aryl(C1-C30)alkyl, (C2-C30)alkenyl, and (C1-C30)alkyl(C6-C20)aryl, and R² is selected from hydrogen, (C1-C30)alkyl, halo(C1-C30)alkyl, (C6-C20)aryl, (C6-C20)aryl(C1-C30)alkyl, and (C1-C30)alkyl(C6-C20)aryl, and the alkyl, alkenyl, aryl, arylalkyl, alkoxy, or alkylaryl of R, and the alkyl, haloalkyl, alkenyl, aryl, arylalkyl, or alkylaryl of R¹ may be further substituted with one or more substituents selected from halogen, hydroxyl, -N(R¹¹)(R¹²), -S(R¹³), -C(=O)R¹⁴, and -O-C(=O)R¹⁵ where each of the R¹¹, the R¹², R¹³, R¹⁴, and R¹⁵ is independently selected from hydrogen and (C1-C30)alkyl, (C6-C20)aryl, and (C2-C30)alkenyl. In preferred embodiments, the group R of the silane compound is selected from (C3-C20)alkyl, (C6-C12)aryl, (C6-C12)aryl(C3-C20)alkyl, (C3-C20)alkyl(C6-C12)aryl, R¹ is selected from hydrogen, hydroxyl, halogen, (C1-C20)alkyl, (C6-C12)aryl, (C6-C12)aryl(C1-C20)alkyl, and (C1-C20)alkyl(C6-C12)aryl, and R² is selected from hydrogen, (C1-C20)alkyl, halo(C1-C20)alkyl, (C6-C12)aryl, (C6-C12)aryl(C1-C20)alkyl, and (C1-C20)alkyl(C6-C12)aryl, and the alkyl, aryl, arylalkyl or alkylaryl of R, and the alkyl, aryl, arylalkyl or alkylaryl of R¹ may be further substituted with one or more substituents selected from halogen, hydroxyl, -N(R¹¹)(R¹²) and -S(R¹³), where each of the R¹¹, the R¹², and the R¹³ is independently selected from hydrogen and (C1-C20)alkyl.

Any features of any embodiment of the second aspect may be independently as correspondingly described for any embodiment of the first aspect of the present invention.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

### Example 1: Cleaning after active layer etch

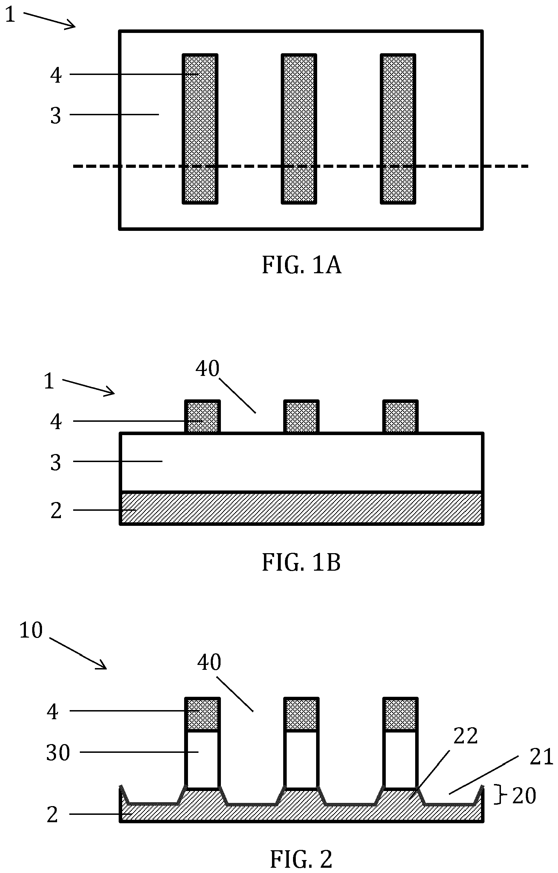

In this example, a first exemplary method is detailed, which is for forming one or more complementary-type field effect transistors, in accordance with embodiments of the present invention. Reference is made to FIG. 1A, which is a top view of a first intermediate structure 1 in accordance with embodiments of the present invention, and FIG. 1B, which shows a vertical cross-section of said first intermediate structure 1 along the dashed line shown in FIG. 1A.

The first intermediate structure 1 comprises a substrate 2, a layer to be patterned 3 covering the substrate 2, and a first hard mask 4 over, e.g., on, the layer to be patterned 3, the first hard mask 4 having openings 40.

In this example, the layer to be patterned 3 comprises a channel material, for example, a stack of layers for forming nanosheets. For example, the stack of layers may comprise alternating layers formed of silicon and silicon-germanium.

The substrate 2 may be a silicon-on-insulator or a semiconductor substrate, such as crystalline silicon, gallium-arsenide, gallium-nitride, or gallium-phosphate.

The hard mask 4 is, in this example, formed of an oxide material, such as silicon oxide, e.g., silicon dioxide. Alternatively, the hard mask 4 may be silicon oxide on silicon nitride (in which case the oxide surfaces of the hard mask are exposed surfaces of the silicon oxide).

Reference is made to FIG. 2, which shows a vertical cross-section of a second intermediate structure 10 formed from the first intermediate structure by dry etching the layer to be patterned through the openings 40 in the hard mask 4. The dry etching technique, e.g., plasma etching such as reactive-ion etching, is typically an anisotropic, hence directional, etching technique. The thus formed second intermediate structure 10 comprises, in this example, fins 30 formed of the channel material on the substrate 2. The second intermediate structure 10 comprises one or more exposed oxide surfaces, in this example, the exposed surfaces of the hard mask 4. The hard mask 4 overlies and is aligned with the fins 30 formed of the channel material.

In this example, the dry etch has proceeded into an upper part 20 of the substrate 2. Thereby, recesses 21 are formed in the substrate 2, located between the fins 30 comprising the channel material. The upper part 20 of the substrate 20 comprises walls 22, formed of substrate material of the upper part 20 of the substrate 2 not removed by said dry etch, on which the fins 30 are located.

The dry etch may result in residues (not shown) over surfaces of the second intermediate structure 10. These residues may be detrimental to the conformity and functioning of the complementary-type field effect transistors formed in this example with the method in accordance with embodiments of the present invention. Therefore, typically, after performing the dry etch, and preferably before covering the second intermediate structure 10 with a further layer for the complementary-type field effect transistor on the second intermediate structure 10 (such as a conformal gate oxide layer, a gate material or a dummy gate material), a cleaning step is performed to remove said residues. In embodiments of the present invention, the cleaning step is performed using a solution comprising hydrogen fluoride.

The dry etch damages oxides, in this example, the hard mask 4, which may be due to collision of plasma ions and the oxides. The damaged oxides have a higher oxidation state and charge, resulting in a higher etch rate when the solution comprising hydrogen fluoride would be applied to said oxides so that the oxides would be etched, e.g., partially removed, which is unwanted.

Said exposed oxide surfaces of the hard mask 4 are reacted with a silane compound of chemical formula R-Si(R¹)ₙ(OR²)₃₋ₙ, wherein R is an organyl group, R¹ is selected from hydrogen, hydroxyl, halogen, and an organyl group, R² is selected from hydrogen and an organyl group, and n is an integer selected in the range of from 0 to 2. Said silane compound used to react with said exposed oxide surfaces may be dispersed in a solvent. The solution comprising the solvent and silane may be applied or dispensed to surfaces of the second intermediate structure 10 using a spinning tool or spin coating device. The solution may be applied at room temperature or at an elevated temperature, such as at a temperature of from 20 to 100°C, e.g., from 30 to 60°C, such as at 40°C. The solution may be applied for a period of from 10 to 120 seconds. Applying the solution may comprise continuously dispensing the solution onto the second intermediate structure 10 during this period. For example, when the second intermediate structure 10 is contained in a 12-inch wafer, the solution may be applied at a rate of from 100 to 500 ml/min. Any unreacted silane remains in the solution and is removed after the period, e.g., by rinsing the second intermediate structure 10.

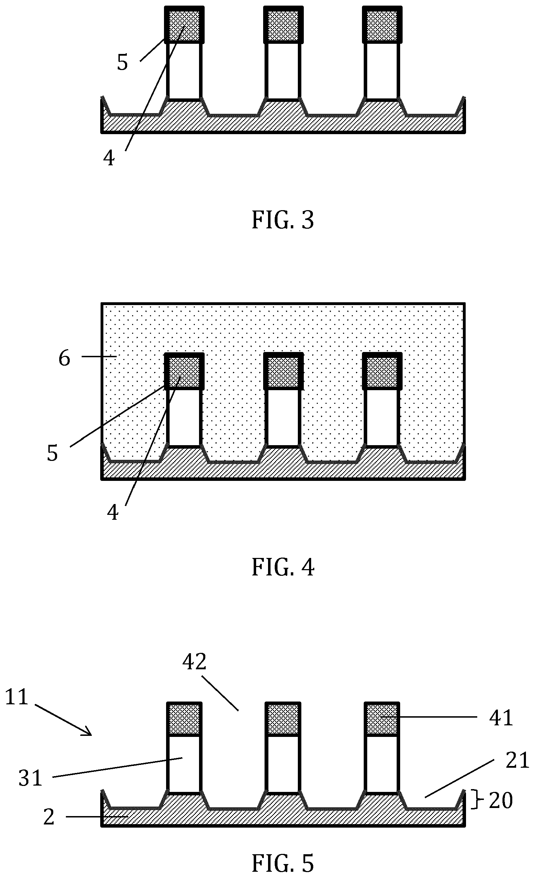

Reference is made to FIG. 3. Thereby, the oxide surfaces of the hard mask 4 are covered by the silane compound 5 bonded to said oxide surface, said silane compound having a chemical formula R-Si(R¹)ₙ(OR²)₂₋ₙ, wherein R is an organyl group, R¹ is selected from hydrogen, hydroxyl, halogen, and an organyl group, R² is selected from hydrogen and an organyl group, and n is an integer selected in the range of from 0 to 2.

Reference is made to FIG. 4. Subsequently, a solution 6 comprising hydrogen fluoride is applied to surfaces of the second intermediate structure 10. Said silane compound 5 protects the hard mask 4 so that the solution 6 comprising hydrogen fluoride may be prevented from reaching the hard mask 4. Said silane compound 5 may form a barrier between the solution 6 and the hard mask 4, so that the hard mask 4 may remain undamaged during cleaning with the solution 6.

Afterwards, but not shown, the solution 6 comprising hydrogen fluoride may be removed, for example, by rinsing with water. Subsequently, the silane compound 5 may be removed to expose the surfaces of the hard mask 4. Said removal of the silane compound 5 may be performed by any suitable means such as using a dry stripping step by applying an oxidizing or non-oxidizing plasma; or exposing the silane compound 5 to ultraviolet radiation.

### Example 2: Cleaning after (dummy) gate layer etch

In this example, a second exemplary method is detailed, which is for forming one or more fin-type or complementary-type field-effect transistors, in accordance with embodiments of the present invention.

Reference is made to FIG. 5, which is a preliminary intermediate structure 11 in accordance with embodiments of the present invention. Said preliminary intermediate structure 11 comprises a plurality of fins 31 comprising a channel material. The channel material may be a channel material, such as silicon (which is a typical channel material for fin-type field-effect transistors) or a stack of layers for forming nanosheets (which is a typical channel material for complementary-type field-effect transistors). Said fins 31 protrude from the substrate 2. The preliminary intermediate structure 11 comprises recesses 21 in an upper part 20 of the substrate 2 between the fins 31. In this example, the preliminary intermediate structure 11 comprises a preliminary hard mask 41 overlying and aligned with the fins 31. In this example, the substrate 2 and the fins 31 may be formed of different materials (e.g., when the method is for forming a complementary type field-effect transistor), but instead, the substrate 2 and the fins 31 may be formed of the same material such as Si, for example, when the fins 31 are for forming the channel of a fin-type field-effect transistor.

The preliminary intermediate structure 11 may be formed using a method similar as in the first example detailed above. The preliminary intermediate structure 11 may be formed by providing the substrate 2, then providing on the substrate 2 a layer comprising a channel material, then providing the preliminary hard mask 41 having openings 42, over, e.g., on, the layer comprising a channel material, and then dry etching the layer comprising a channel material and the upper part 20 of the substrate 2, through the openings 42 in the preliminary hard mask 41, thereby forming the preliminary intermediate structure 11.

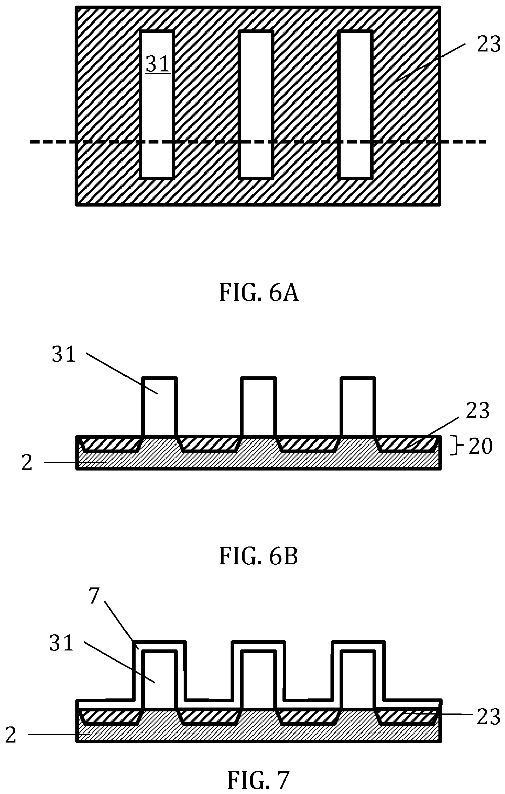

Subsequently, shallow trench isolations are formed. This may be done by covering the preliminary intermediate structure 11, including the preliminary hard mask, thereby filling the recesses 21 and spaces between the fins 31 comprising a channel material with the oxide material. Subsequently, chemical mechanical polishing and then an etch back may be performed to remove oxide material located outside of the trenches. In this example, the preliminary hard mask 41 is removed as well by said etch back. Thereby, the recesses 21 are filled with the oxide material, e.g., silicon dioxide, to form shallow trench isolations 23 in the upper part 20 of the substrate 2, as shown in the top view of FIG. 5A, and the vertical cross-section in FIG. 6B, which is the cross-section along the dashed line in FIG. 6A.

Reference is made to FIG. 7. Subsequently, an oxide material 7, such as silicon oxide, may be deposited to conformally cover the substrate 2, the shallow trench isolations 23, and the fins 31 comprising the channel material. Said conformal oxide material 7 may function as a gate oxide in the fin-type or complementary-type field-effect transistors to be formed. Said deposition may be performed with chemical vapor deposition or chemical vapor deposition, such as atomic layer deposition. In alternative embodiments, no conformal oxide material 7 is deposited.

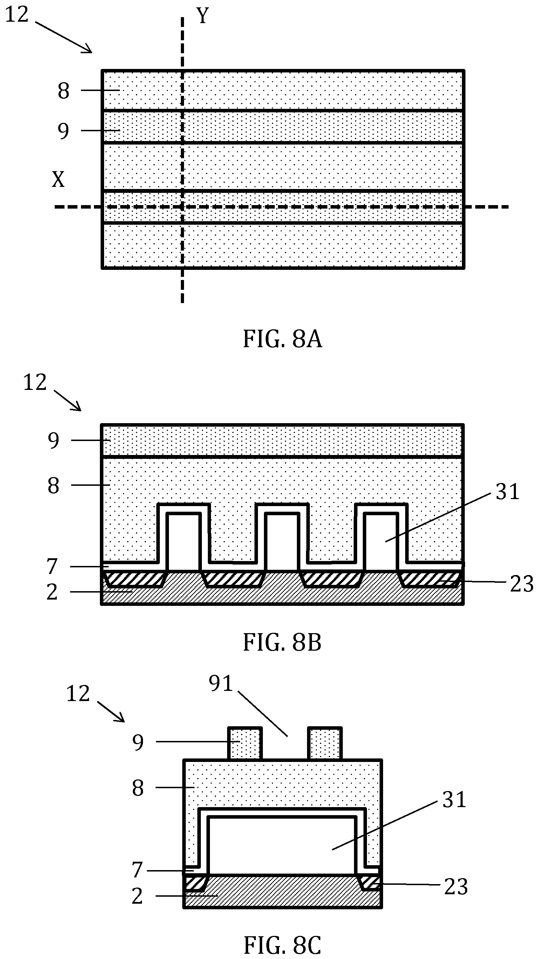

Reference is made to FIG. 8A, which is a top view of a first intermediate structure 12 in accordance with embodiments of the present invention, to FIG. 8B, which is a vertical cross-section along the line X shown in FIG. 8A, and to FIG. 8C, which is a vertical cross-section along the line Y shown in FIG. 8A. A layer of gate or dummy gate material 8 is deposited at least covering the substrate 2, the shallow trench isolations 23, and the fins 31 comprising a channel material. As this example comprises the conformal oxide material 7, said conformal oxide material 7 is covered as well with the layer of gate or dummy gate material 8.

Subsequently, over, e.g., on, the gate or dummy gate material 8, a first hard mask 9 having openings 91 is provided.

Thereby, the first intermediate structure 12 of this example in accordance with embodiments of the present invention is formed. Herein, the first intermediate structure 12 comprises the substrate 2, and the plurality of fins 31 comprising a channel material, protruding from the substrate 2. The first intermediate structure 12 further comprises recesses in the substrate 2 between the fins 31 with the shallow trench isolations 23 located in the recesses and formed of an oxide material. The first intermediate structure 12 further comprises the conformal oxide material 7 covering the substrate 2, the shallow trench isolations 34, and embedding the plurality of fins 31. The first intermediate structure 12 further comprises the layer to be patterned 8 that is, in this example, the layer of gate or dummy gate material 8 covering, in this example, the conformal oxide material 7, and covering the substrate 2, the shallow trench isolations 34, and embedding the plurality of fins 31. The first intermediate structure 12 further comprises the first hard mask 9 having openings 91.

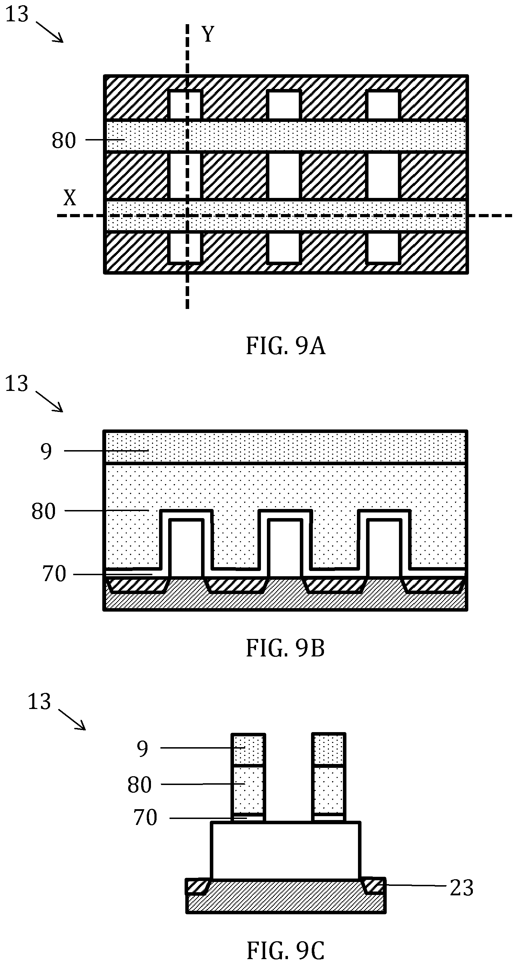

Dry etching, typically an anisotropic or directional etch, e.g., a plasma etch, is performed, through the openings 91 in the hard mask 9, on the layer to be patterned 8 and the conformal oxide material 7. Reference is made to FIG. 9A, which is a top view of a second intermediate structure 13 in accordance with embodiments of the present invention, to FIG. 9B, which is a vertical cross-section along the line X shown in FIG. 9A, and to FIG. 9C, which is a vertical cross-section along the line Y shown in FIG. 9A. By said dry etch, the second intermediate structure 13 is formed. Herein, the layer to be patterned has been dry etched to form a plurality of gates or dummy gates 80, overlying and aligned with patterned conformal oxide material 70. The first hard mask 9 overlies and is aligned with plurality of gates or dummy gates 80.

The second intermediate structure 13 comprises one or more exposed oxide surfaces. In this example, the shallow trench isolations 23, the first hard mask 9 and the patterned conformal oxide material 70, each of which is, in this example, formed of an oxide material, comprise exposed oxide surfaces.

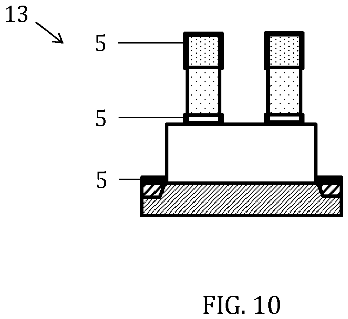

Reference is made to FIG. 10, which is a vertical cross-section that is the same cross-section as shown in FIG. 9C, but after reacting oxide surfaces with a silane compound. To remove residues (not shown) from the dry etch without further damaging the exposed oxide surfaces, said exposed oxide surfaces are reacted with a silane compound of chemical formula R-Si(R¹)ₙ(OR²)₃₋ₙ, wherein R is an organyl group, R¹ is selected from hydrogen, hydroxyl, halogen, and an organyl group, R² is selected from hydrogen and an organyl group, and n is an integer selected in the range of from 0 to 2. Thereby, said oxide surfaces are covered by a silane compound bonded to said oxide surfaces, said silane compound having a chemical formula R-Si(R¹)ₙ(OR²)₂₋ₙ, wherein R is an organyl group, R¹ is selected from hydrogen, hydroxyl, halogen, and an organyl group, R² is selected from hydrogen and an organyl group, and n is an integer selected in the range of from 0 to 2.

Subsequently, the second intermediate structure 13, i.e., an intermediate in the formation of a plurality of fin-type or complementary-type field-effect transistors in accordance with embodiments of the present invention, and having reacted oxide surfaces is cleaned by contacting it with a solution comprising hydrogen fluoride (not shown). After that, the silane compound bonded to said oxide surfaces may be removed.

Next, further steps may be performed to form the plurality of fin-type or complementary-type field-effect transistors, including forming source/drain contacts, and interconnects (not shown).

Although, above, in the first example, said cleaning is performed after a dry etch to form channels, while in the second example, cleaning while protecting oxide surface with silane, is performed after a dry etch to form gates or dummy gates, these embodiments could be combined with each other and cleaning while protecting oxide surface with silane may be performed both after the dry etch to form channels and after the dry etch to form gates or dummy gates.

It is to be understood that although preferred embodiments, specific constructions and configurations, as well as materials, have been discussed herein for devices according to the present invention, various changes or modifications in form and detail may be made without departing from the scope of this invention. Steps may be added or deleted to methods described within the scope of the present invention.

## Claims

1. A method for forming one or more fin-type or complementary-type field-effect transistors, comprising:
i) providing a first intermediate structure (1, 12) comprising:
- a layer to be patterned (3, 8), and
- a first hard mask (4, 9) having openings (40, 91),
ii) dry etching the layer (3,8) through the openings (40, 91) in the hard mask (4, 9), thereby forming a second intermediate structure (10, 13), wherein the second intermediate structure (10, 13) comprises one or more exposed oxide surfaces,
iii) reacting said exposed oxide surfaces with a silane compound (5) of chemical formula R-Si(R¹)ₙ(OR²)₃₋ₙ, wherein R is an organyl group, R¹ is selected from hydrogen, hydroxyl, halogen, and an organyl group, R² is selected from hydrogen and an organyl group, and n is an integer selected in the range of from 0 to 2, and then
iv) cleaning the second intermediate structure (10, 13) having reacted oxide surfaces by contacting it with a solution (6) comprising hydrogen fluoride.

2. The method according to claim 1, wherein the layer to be patterned is a layer of gate or dummy gate material (8) and wherein the second intermediate structure (13) comprises one or more gates or dummy gates (80).

3. The method according to claim 2, wherein the method is for forming a plurality of fin-type or complementary-type field-effect transistors and wherein the first intermediate structure (12) comprises:
- a substrate (2),
- a plurality of fins (31) comprising a channel material, protruding from the substrate (2), and
- recesses (21) in the substrate (2) between the fins (31),
- shallow trench isolations (23) located in the recesses (21) and formed of an oxide material,
- said layer of gate or dummy gate material (8) covering the substrate (2), the shallow trench isolations (23), and embedding the plurality of fins (31).

4. The method according to claim 3, wherein forming the first intermediate structure (12) comprises:
Ia) providing the substrate (2), then
Ib) providing on the substrate (2) a layer comprising a channel material,
Ic) providing a preliminary hard mask (41) having openings (42), over the layer comprising a channel material,
Id) dry etching a) the layer comprising a channel material and b) an upper part (20) of the substrate (2), through the openings (42) in the preliminary hard mask (41), thereby forming a preliminary intermediate structure (11) comprising the plurality of fins (31) comprising a channel material, said fins (31) protruding from the substrate (2), and recesses (21) in the substrate (2) between the fins (31) comprising a channel material,
Ie) forming the shallow trench isolations (23) by filling the recesses (21) with an oxide material,
If) covering the substrate (2), the shallow trench isolations (23), and the fins (31) comprising a channel material, with the layer of gate or dummy gate material (8), and
Ig) providing over the gate or dummy gate material (8) the first hard mask (9) having openings (91).

5. The method of claim 4, further comprising a step Ie' between step Ie and step If of conformally covering the substrate (2), the shallow trench isolations (23), and the fins (31) with an oxide material (7), and wherein step If covers this oxide material (7).

6. The method of any one of claims 3 to 5, wherein the plurality of fins (31) comprising a channel material comprises a patterned stack of layers for forming nanosheets.

7. The method of claim 1, wherein the method is for forming one or more complementary-type field effect transistors, wherein the layer to be patterned (3) comprises a stack of layers (3) for forming nanosheets.

8. The method of claim 7, wherein the stack of layers (3) comprises alternating layers formed of silicon and silicon-germanium.

9. The method of any of the previous claims, wherein the group R of the silane compound comprises a chain of atoms having a chain length of from 1 to 30 atoms.

10. The method of any of the previous claims, wherein the group R¹ and/or the group R² of the silane compound comprises a chain of atoms having a chain length of from 1 to 30 atoms.

11. The method of any of the previous claims, wherein the group R of the silane compound is selected from (C1-C30)alkyl, (C6-C20)aryl, (C2-C30)alkenyl, (C6-C20)aryl(C1-C30)alkyl, (C1-C30)alkyl(C6-C20)aryl, and (C1-C30)alkoxy, R¹ is selected from hydrogen, hydroxyl, halogen, (C1-C30)alkyl, (C6-C20)aryl, (C6-C20)aryl(C1-C30)alkyl, (C2-C30)alkenyl, and (C1-C30)alkyl(C6-C20)aryl, and R² is selected from hydrogen, (C1-C30)alkyl, halo(C1-C30)alkyl, (C6-C20)aryl, (C6-C20)aryl(C1-C30)alkyl, and (C1-C30)alkyl(C6-C20)aryl, and the alkyl, alkenyl, aryl, arylalkyl, alkoxy, or alkylaryl of R, and the alkyl, haloalkyl, alkenyl, aryl, arylalkyl, or alkylaryl of R¹ may be further substituted with one or more substituents selected from halogen, hydroxyl, -N(R¹¹)(R¹²), -S(R¹³), -C(=O)R¹⁴, and -O-C(=O)R¹⁵ where each of the R¹¹, the R¹², R¹³, R¹⁴, and R¹⁵ is independently selected from hydrogen and (C1-C30)alkyl, (C6-C20)aryl, and (C2-C30)alkenyl.

12. The method of claim 11, wherein the group R of the silane compound is selected from (C3-C20)alkyl, (C6-C12)aryl, (C6-C12)aryl(C3-C20)alkyl, (C3-C20)alkyl(C6-C12)aryl, R¹ is selected from hydrogen, hydroxyl, halogen, (C1-C20)alkyl, (C6-C12)aryl, (C6-C12)aryl(C1-C20)alkyl, and (C1-C20)alkyl(C6-C12)aryl, and R² is selected from hydrogen, (C1-C20)alkyl, halo(C1-C20)alkyl, (C6-C12)aryl, (C6-C12)aryl(C1-C20)alkyl, and (C1-C20)alkyl(C6-C12)aryl, and the alkyl, aryl, arylalkyl or alkylaryl of R, and the alkyl, aryl, arylalkyl or alkylaryl of R¹ may be further substituted with one or more substituents selected from halogen, hydroxyl, -N(R¹¹)(R¹²) and - S(R¹³), where each of the R¹¹, the R¹², and the R¹³ is independently selected from hydrogen and (C1-C20)alkyl.

13. The method of any of the previous claims, wherein the solution (6) has a concentration of at most 2 wt-% hydrogen fluoride.

14. The method of any of the previous claims, wherein the solution (6) is applied for a period of at most 120 seconds to the surfaces of the second intermediate structure (10, 13).

15. An intermediate (13) in the formation of a plurality of fin-type or complementary-type field-effect transistors, comprising:
- a substrate (2),
- a plurality of fins (31) comprising a channel material, protruding from the substrate (2), and
- recesses (21) in the substrate (2) between the fins (31),
- shallow trench isolations (23) located in the recesses (21) and formed of an oxide material, and
- a plurality of gates or dummy gates (80), and
- a first hard mask (9) overlying and aligned with the plurality of gates or dummy gates (80),
the intermediate (13) comprising oxide surfaces covered by a silane compound (5) bonded to said oxide surfaces, said silane compound (5) having a chemical formula R-Si(R¹)ₙ(OR²)₂₋ₙ, wherein R is an organyl group, R¹ is selected from hydrogen, hydroxyl, halogen, and an organyl group, R² is selected from hydrogen and an organyl group, and n is an integer selected in the range of from 0 to 2.
